# Europäisches Patentamt

## European Patent Office
⑩

## Office européen des brevets

(11) Publication number: **0 082 861**
**B1**

(12) # EUROPEAN PATENT SPECIFICATION

(45) Date of publication of patent specification: **27.11.85**

(51) Int. Cl.⁴: **G 08 B 13/02**

(21) Application number: **82902065.0**

(22) Date of filing: **06.07.82**

(86) International application number:
**PCT/DK82/00063**

(87) International publication number:
**WO 83/00246 20.01.83 Gazette 83/02**

(54) **ALARM SYSTEM FOR SAFEGUARDING AGAINST THE BREAKTHROUGH OF A SURFACE.**

| | |
|---|---|
| (30) Priority: **06.07.81 DK 2979/81** | (73) Proprietor: **JORGENSEN, Poul Richter**<br>**Strandvej 14**<br>**DK-4573 Hojby Sjaelland (DK)** |
| (43) Date of publication of application:<br>**06.07.83 Bulletin 83/27** | |
| | (72) Inventor: **JORGENSEN, Poul Richter**<br>**Strandvej 14**<br>**DK-4573 Hojby Sjaelland (DK)** |
| (45) Publication of the grant of the patent:<br>**27.11.85 Bulletin 85/48** | |
| | (74) Representative: **Patentanwälte Grünecker, Dr.**<br>**Kinkeldey, Dr. Stockmair, Dr. Schumann, Jakob,**<br>**Dr. Bezold, Meister, Hilgers, Dr. Meyer-Plath**<br>**Maximilianstrasse 58**<br>**D-8000 München 22 (DE)** |
| (84) Designated Contracting States:<br>**CH DE FR GB LI NL SE** | |
| (56) References cited:<br>**DE-C- 149 079**<br>**US-A-3 594 770**<br>**US-A-3 634 845**<br>**US-A-3 772 674** | |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

This invention relates to an alarm system for safeguarding against the breaking through of a surface, according to the precharacterizing part of patent claim 1. An alarm system of this kind is known from US—A—3 594 770.

With the known system, the leads lying in different planes of the surface to be protected are connected to different terminals of an electronic device without being interconnected with each other. It is, therefore, possible, in principle, for a criminal to remove a section of a lead after having short-circuited its ends with the help of a longer length of lead. In this manner, it is possible, with repeated operations, to make a chosen area of the surface insensitive at first in the first plane and then in the second plane of leads.

The DE—A—149 079 shows an alarm system using only one lead being arranged in a net-like pattern in two planes of a surface, so that there are only two terminals for the single lead forming a closed loop. As in the first-mentioned case, by short-circuiting this loop, it can be rendered insensitive. US—A—3 634 845 shows a window security system in which a pair of electrically conductive strips extend across a window with a bias voltage source connected across one end of the strips and an alarm-actuating circuit connected across the other end of the strips, the alarm-actuating circuit being capable of energizing the alarm if the strips are broken or if they are bridged. Also, in this arrangement, bridging the ends of the leads will render the system insensitive.

It is an object of the invention to provide an alarm system of the above-mentioned kind which is simple in construction and provides a high degree of security.

According to the invention, there are provided at least three wires in a set of wires, this set running uninterrupted through both surfaces to be protected, so that a number of input terminals, and the same number of output terminals, belong to the assembled network, and in which at least some of the signals provided at the different wires by the power source optionally differ from each other and the electronic circuit is arranged to activate an alarm in the event of the signal on just one of the output terminals not corresponding to the signal on the corresponding input terminal.

By this arrangement, it becomes very difficult to render the system insensitive, as it is hard to recognize which terminals are to be short-circuited in order to keep the system ineffective. As the different wires of the set of wires may have different signals (voltages), an additional bar is provided which can hardly ever be overcome by a criminal.

Keeping the distance between the individual wires in different surfaces less than 0.5 mm is a further feature for enhancing the effect of the system.

By dimensioning such a system in a suitable manner, i.e. with conveniently close lying wires seen both in the directions of the above-mentioned planes and at right angles thereto, the removal of a section of a given wire can be made very difficult without, at the same time, damaging the wires in another layer and thereby activating the alarm. It will be obvious that the breadth and the pattern or patterns of the wires can be varied considerably without deviating from the scope of the invention.

The wires may be molded into, or enclosed in, one or more insulating material, for example by being laid out and secured on both sides of an insulating support layer and thereafter covered with an insulating covering material. There is hereby provided a finished product which can be dispatched without being damaged and which thereafter can be mounted at the place of application.

The invention will now be described in closer detail with reference to the accompanying drawings wherein,

FIG. 1 shows in schematic form the run of a set of wires used in an alarm system according to the invention but where, for the sake of clarity, the breadth of the set is greatly reduced,

FIG. 2 shows, in more detail, the actual mutual distance between the wires but where, on the other hand, the effective barrier area of the wire network is reduced out of regard for clarity,

FIG. 3 shows a coupling diagram for an alarm system according to the invention, and

FIG. 4 is a table showing the relationship between input and output with regard to Fig. 3.

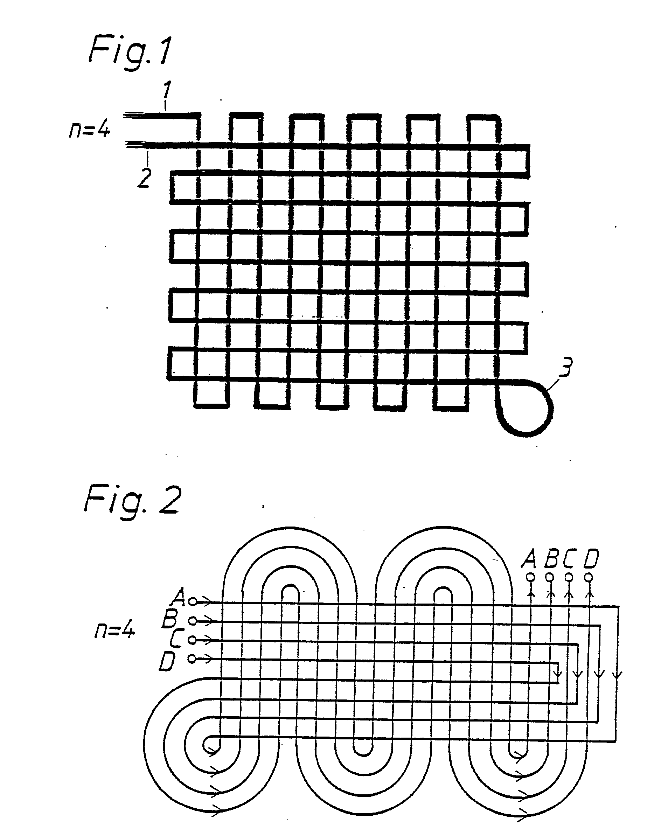

In Fig. 1 the run of a set of wires is shown schematically by a broad black line. The one end of the set is shown at 1 and the other end at 2. The set consists of 4 wires but, for the sake of clarity, the four wires are shown as a broad black line, which, in effect, is not broad enough, in that the distance between the individual parts of the set in the places where it runs parallel to itself is just as small as the distance between the individual wires. The first part of the set which, in the main, consists of vertical lines, is mounted on the one side of a support layer, for example in the form of a printed circuit on a printboard, while the second part of the set, which, in the main, consists of horizontal lines (on the paper), is mounted on the other side of the support layer. The transition from the one side to the other takes place at the loop 3, and this transition is to be considered schematic, in that in practice it would be executed in another manner. The support layer or the printboard can then be secured to or comprise a part of a wall in a suitcase or a strongbox, in that the whole of the wall surface is then covered.

As mentioned, the parallel parts of the set 1 lie closer at the side of each other than shown in Fig. 1. Fig. 2 shows a more realistic distance between the wires, where all the wires comprising the system lie at the same distance from each other in a square net. On the other hand, the effective barrier area in this schematic arrangement is very small in relation to the ineffective fringe area, which in practice does not occupy so much space.

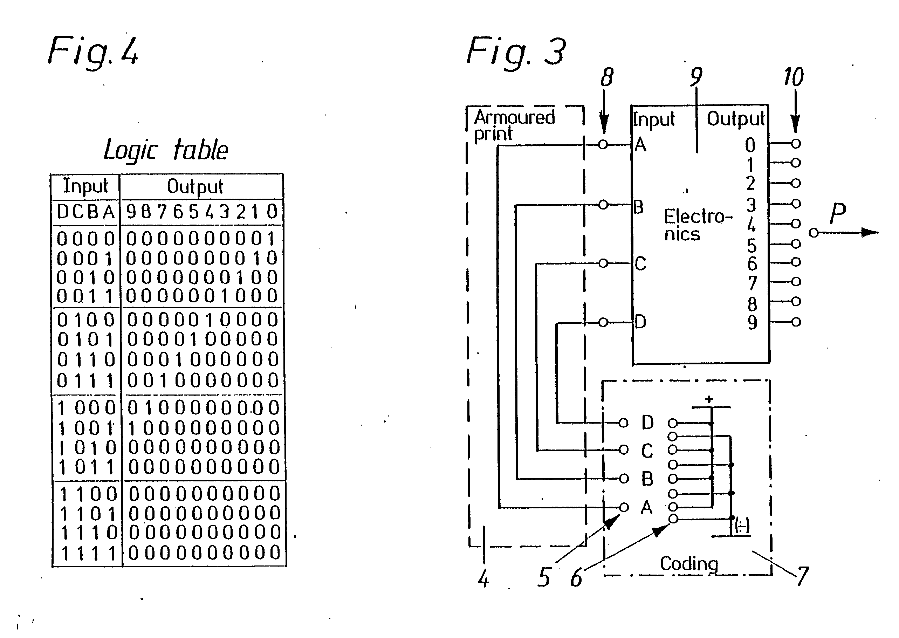

Fig. 3 shows a coupling diagram with a support layer or armoured print 4 symbolized by a dotted line, and which is imagined to contain that described in Figs. 1 and 2. Four input terminals can be connected to the terminals 6 in a power source 7. Every second of these terminals 6 are live, while the others are connected to earth. For a given production example one chooses to connect some of the terminals 5 to a live terminal, while the remainder are connected to earth. The output terminals 8 on the support layer or the armoured print 4 are connected to a microprocessor or an electronic unit 9 containing generally known electronics capable of distinguishing between the possible combinations, and which is arranged to furnish an alarm symbolized by the arrow P in the event of the output not corresponding to the input at 5 and 6.

Fig. 4 shows the possible combinations. Here it must be pointed out that in the case of a certain production example, no exchange is made between the mentioned combinations. For a given production example one chooses to use one of the possible combinations. For example, one can decide that the terminals A and B are to be current-carrying, while the remainder are to be connected to earth. This corresponds to line 4 in the table in Fig. 4, where 1 signifies current-carrying and 0 signifies connection to earth. In the electronic unit 9 is placed a decoder which can accommodate 10 combinations — one will often prefer that this can accommodate all 16 combinations. The invention is naturally not limited to the use of four wires in a set (n = 4) but in practice it has proved that four wires and ten combinations are more than sufficient to provide the desired protection. With the example mentioned the protection is thus achieved by a voltage being applied to terminal 3 in the row 10, while the other terminals remain voltage-free in relation to earth. The system is arranged to provide an alarm signal at the instant that this is not the case, and thus the alarm signal is produced when,

1) one of the current-carrying wires A or B is cut over,

2) one of the current-carrying wires is connected to something which diverts the current, including for example one of the remaining leads,

3) a voltage is applied to one of the leads connected to earth.

As the wires in the support layer as shown in Fig. 1 and 2 can be arranged to lie very close to one another, and since a criminal attempting to break through cannot know which of the wires are current-carrying and which are not, it becomes impossible in practice to make holes in the support layer which are substantially larger than the size of the mesh.

## Claims

1. Alarm system for safeguarding against the breaking through of a surface, for example a wall, the wall of a suitcase or a pane of glass, said system being of the kind in which a pattern or network of electrically conducting leads or wires are uniformly distributed over said surface, and the wires are placed in at least two surfaces, preferably plane surfaces, lying at a small distance from each other seen at right angles to the surfaces and where an electronic circuit is being used to survey the wires which can be given a signal from a power source, characterized in that the wires are comprised in a set consisting of three or more wires, that the respective wires in this set run uninterrupted through both surfaces so that to the assembled network there belongs a number of input terminals (A, B, C, D) and the same number of output terminals (A, B, C, D), that at least some of the signals provided at the different wires by the power source optionally differ from each other, and that the electronic circuit (9) is arranged to activate an alarm in the event of the signal on just one of the output terminals not corresponding to the signal on the corresponding input terminal.

2. System according to claim 1, characterized in that the distance between the individual wires in different surfaces is less than 0.5 mm.

3. System according to claim 1 or 2, characterized by the set comprising four wires.

4. System according to any of the preceding claims, characterized in that the electronic circuit (9) is a microprocessor.

## Patentansprüche

1. Alarmsystem zur Sicherstellung gegen Durchbruch einer Oberfläche, beispielsweise einer Wand, einer Kofferwand oder einer Glasscheibe, wobei das System von der Art ist, bei der ein Muster oder Netzwerk elektrisch leitender Leiter oder Drähte gleichförmig über die Oberfläche verteilt sind und die Drähte in wenigstens zwei Oberflächen, vorzugsweise ebenen Oberflächen angeordnet sind, die in geringer Distanz zueinander liegen, im rechten Winkel zu den Oberflächen gesehen, und wobei ein elektronischer Schaltkreis dazu verwendet wird, die Drähte zu überwachen, dem ein Signal von einer Stromquelle zugeführt sein kann, dadurch gekennzeichnet, daß die Drähte in einem Satz angeordnet sind, bestehend aus drei oder mehr Drähten, daß die entsprechenden Drähte in diesem Satz ununterbrochen über beide Oberflächen laufen, so daß zu dem zusammengesetzten Netzwerk eine Anzahl von Eingangsanschlüssen (A, B, C, D) und eine gleiche Anzahl von Ausgangsanschlüssen (A, B, C, D) gehört, daß wenigstens einige der an den verschiedenen Drähten von der Stromquelle zur Verfügung gestellten Signale wahlweise voneinander abweichen und daß der elektronische Schaltkreis (9) dazu eingerichtet ist, einen Alarm auszulösen im Falle, daß das Signal an gerade einem der Ausgangsanschlüsse nicht mit dem Signal am zugehörigen Eingangsanschluß übereinstimmt.

2. System nach Anspruch 1, dadurch gekennzeichnet, daß die Distanz zwischen den einzelnen Drähten in verschiedenen Oberflächen geringer als 0,5 mm ist.

3. System nach Anspruch 1 oder 2, dadurch gekennzeichnet, daß der Satz vier Drähte enthält.

4. System nach einem der vorhergehenden Ansprüche, dadurch gekennzeichnet, daß der elektronische Schaltkreis (9) ein Mikroprozessor ist.

**Revendications**

1. Dispositif d'alarme pour se protéger contre le percement d'une surface, par exemple un mur, la paroi d'une valise ou un panneau de verre, ce dispositif étant du type dans lequel un modèle ou réseau de conducteurs ou fils conducteurs de l'électricité sont uniformément disposés sur cette surface, et les fils sont disposés dans au moins deux surfaces, de préférence deux surfaces planes, à petite distance les uns des autres, vus perpendiculairement aux surfaces, et dans lequel un circuit électronique est utilisé pour surveiller les fils pouvant recevoir un signal d'une source de courant, caractérisé en ce que les fils constituent un jeu comprenant trois fils ou davantage, que les fils respectifs dans ce jeu courent de façon ininterrompue sur les deux surfaces de sorte qu'un certain nombre de bornes d'entrée (A, B, C, D) et le même nombre de bornes de sortie (A, B, C, D) appartiennent au réseau assemblé, qu'au moins certains des signaux procurés sur les différents fils par la source de courant diffèrent au choix l'un de l'autre et que le circuit électronique (9) est disposé pour déclencher une alarme dans le cas où le signal sur l'une des bornes de sortie ne correspond pas au signal sur la borne d'entrée correspondante.

2. Dispositif selon la revendication 1, caractérisé en ce que la distance entre les fils individuels dans les différentes surfaces est inférieure à 0,5 mm.

3. Dispositif selon la revendication 1 ou la revendication 2, caractérisé en ce que le jeu comprend quatre fils.

4. Dispositif selon l'une quelconque des revendications précédentes, caractérisé en ce que le circuit électronique (9) est un microprocesseur.

*Fig.1*

*Fig. 2*

0 082 861

## Fig. 4

### Logic table

| Input | Output |
|---|---|
| D C B A | 9 8 7 6 5 4 3 2 1 0 |
| 0 0 0 0 | 0 0 0 0 0 0 0 0 0 1 |
| 0 0 0 1 | 0 0 0 0 0 0 0 0 1 0 |
| 0 0 1 0 | 0 0 0 0 0 0 0 1 0 0 |
| 0 0 1 1 | 0 0 0 0 0 0 1 0 0 0 |
| 0 1 0 0 | 0 0 0 0 0 1 0 0 0 0 |
| 0 1 0 1 | 0 0 0 0 1 0 0 0 0 0 |
| 0 1 1 0 | 0 0 0 1 0 0 0 0 0 0 |
| 0 1 1 1 | 0 0 1 0 0 0 0 0 0 0 |
| 1 0 0 0 | 0 1 0 0 0 0 0 0 0 0 |
| 1 0 0 1 | 1 0 0 0 0 0 0 0 0 0 |
| 1 0 1 0 | 0 0 0 0 0 0 0 0 0 0 |
| 1 0 1 1 | 0 0 0 0 0 0 0 0 0 0 |
| 1 1 0 0 | 0 0 0 0 0 0 0 0 0 0 |
| 1 1 0 1 | 0 0 0 0 0 0 0 0 0 0 |
| 1 1 1 0 | 0 0 0 0 0 0 0 0 0 0 |
| 1 1 1 1 | 0 0 0 0 0 0 0 0 0 0 |

## Fig. 3